# EUROPEAN PATENT APPLICATION

(11) **EP 3 240 019 A1**
(43) Date of publication of application: **01.11.2017**
(21) Application number: 14908975.7
(22) Date of filing: 24.12.2014
(51) Int. Cl.: H01L 21/316, C01G 33/00, H01L 21/822, H01L 21/8246, H01L 27/04, H01L 27/105

(54) **OXIDE DERIVATIVE, METHOD FOR PRODUCING SAME, PRECURSOR OF OXIDE DERIVATIVE, SOLID-STATE ELECTRONIC DEVICE AND METHOD FOR MANUFACTURING SOLID-STATE ELECTRONIC DEVICE**

(71) Applicant: Japan Advanced Institute of Science and Technology, Ishikawa 923-1292 (JP); Adamant Co., Ltd., Tokyo 123-8595 (JP)
(72) Inventor: SHIMODA, Tatsuya, Ishikawa 923-1292 (JP); INOUE, Satoshi, 10143-9, Toyohira, Chino-shi Nagano 3910213 (JP); ARIGA, Tomoki, Tokyo 1238595 (JP)
(74) Representative: Wächter, Jochen
(86) International application number: PCT/JP2014/084159
(87) International publication number: WO 2016/103368

(57) **Abstract**

[Problem] Provided is an oxide dielectric having superior properties, and a solid state electronic device (for example, a high pass filter, a patch antenna, a capacitor, a semiconductor device, or a microelectromechanical system) including the oxide dielectric.

[Solution] The oxide layer 30 according to the present invention includes an oxide (possibly including inevitable impurities) consisting essentially of bismuth (Bi) and niobium (Nb) and having a crystal phase of the pyrochlore-type crystal structure, in which the number of atoms of the above niobium (Nb) is 1.3 or more and 1.7 or less when the number of atoms of the above bismuth (Bi) is assumed to be 1.

## Description

### TECHNICAL FIELD

The present invention relates to an oxide dielectric, a method of manufacture thereof, and a precursor of an oxide dielectric, and also relates to a solid state electronic device and a method of manufacture thereof.

### BACKGROUND ART

Functional oxide layers with a variety of compositions have been developed in the art. An example of developed solid state electronic devices with such oxide layers includes ferroelectric thin film-containing devices, which are expected to operate at high speed. BiNbO₄ is a Pb-free dielectric material developed for use in solid state electronic devices. BiNbO₄ can be formed as an oxide layer by annealing at relatively low temperature. As to BiNbO₄, there is a report on the dielectric properties of BiNbO₄ formed by solid phase growth technique (Non-Patent Document 1). Some patent documents also disclose oxide layers consisting essentially of bismuth (Bi) and niobium (Nb) and having relatively high dielectric constants of 60 or more (up to 180) at 1 kHz (Patent Documents 1 and 2).

### PRIOR ART DOCUMENTS

### PATENT DOCUMENTS

Patent Document 1: International Publication No. WO 2013/069470 A
Patent Document 2: International Publication No. WO 2013/069471 A

### NON-PATENT DOCUMENT

Non-Patent Document 1: Effect of phase transition on the microwave dielectric properties of BiNbO4, Eung Soo Kim, Woong Choi, Journal of the European Ceramic Society 26 (2006) 1761-1766

### SUMMARY OF THE INVENTION

### PROBLEMS TO BE SOLVED BY THE INVENTION

An oxide consisting essentially of bismuth (Bi) and niobium (Nb) and having a relatively high dielectric constant is obtained. Nonetheless, an ever higher relative dielectric constant than those disclosed in the art is required in order to improve the performance of a solid state electronic device such as a capacitor, a semiconductor device, or a microelectromechanical system. In addition, improvement in electrical properties (including, for example, dielectric loss (tan δ)) and the like is also one of the important technical issues to be achieved. In view of fast-evolving of various smaller and lighter solid state electronic devices, a smaller and lighter capacitor or condenser (hereinafter, generally referred to as a "capacitor") has been strongly demanded in the industry.

In order to obtain a smaller and lighter capacitor, what is required is a thinner dielectric film simultaneously having a higher dielectric constant. However, it is extremely difficult to obtain a thinner dielectric film with a higher dielectric constant while maintaining reliability of a capacitor or a dielectric film.

In view of developing a smaller and lighter composite device, which is an example of other solid state electronic devices, including at least two of a high pass filter, a patch antenna, a semiconductor device, a microelectromechanical system, or RCL, for example, frequency properties need to be improved.

In the conventional art, the efficiency of use of raw materials or production energy is also very low because common processes such as vacuum processes and photolithographic processes take a relatively long time and/or require expensive facilities. The use of such manufacturing methods requires many processes and a long time for the manufacture of solid state electronic devices and thus is not preferred in view of industrial or mass productivity. According to the conventional art, there is also a problem in that large-area fabrication is relatively difficult to perform.

The inventions described in the applications filed to date by the present inventors propose some solutions to the above technical problems with the conventional art. However, solid state electronic devices with high performance and high reliability are yet to be fully achieved.

### SOLUTIONS TO THE PROBLEMS

The present invention solves at least one of the above problems so that a high-performance solid state electronic device can be manufactured using an oxide as at least a dielectric or an insulator (hereinafter collectively referred to as a "dielectric") or such a solid state electronic device can be manufactured by a simplified, energy-saving process. As a result, the present invention can significantly contribute to the provision of an oxide dielectric with high industrial or mass productivity and the provision of solid state electronic devices having such an oxide dielectric.

The present inventors have conducted extensive studies for selecting an oxide appropriately contributing to the performance of a dielectric in a solid state electronic device among many existing oxides, and for developing a method of manufacture thereof. After conducting detailed analysis and research with many trials and errors, the present inventors have found that a very high performance can be achieved by forming an oxide consisting essentially of bismuth (Bi) and niobium (Nb) having a high relative dielectric constant so that the composition ratio of these elements falls within a characteristic range. Further, the present inventors have found that a high-performance dielectric can be more reliably manufactured by taking advantage of this characteristic range of the composition ratio in a part of the manufacturing process of an oxide dielectric.

Further, the present inventors have found that an inexpensive and simple method of manufacturing the above oxide dielectric can be achieved by avoiding a method requiring a high vacuum state. In addition, the present inventors have also found that the oxide layer thereof can be patterned by an inexpensive and simple approach using an "imprinting" process also called as "nanoimprint." As a result, the inventors have created a high-performance oxide and have also found that the formation of such an oxide dielectric and the manufacture of a solid state electronic device having such an oxide dielectric can be achieved using a process that is significantly simpler and more energy-saving than conventional processes and easily allows large-area fabrication. The present invention has been made based on each of the findings described above.

An oxide dielectric according to the present invention includes an oxide (possibly including inevitable impurities. This applies to all oxides disclosed in the present application) consisting essentially of bismuth (Bi) and niobium (Nb) and having a crystal phase of the pyrochlore-type crystal structure. Further, in the above oxide dielectric, the number of atoms of the above niobium (Nb) is 1.3 or more and 1.7 or less when the number of atoms of the above bismuth (Bi) is assumed to be 1.

The above oxide dielectric can show a much higher relative dielectric constant (typically, 220 or more) as compared with the conventional products by virtue of having a crystal phase of the pyrochlore-type crystal structure. Detailed analysis by the present inventors clearly indicates that the relative dielectric constant obtainable from the crystal phase of the pyrochlore-type crystal structure is exceptionally high as compared with that obtainable from a conventional crystal structure (for example, the β-BiNbO₄ crystal structure known in the art). Based on this finding, in an oxide consisting essentially of bismuth (Bi) and niobium (Nb) (hereinafter may also be referred to as a "BNO oxide"), a specific composition ratio can be selected as described above in which the number of atoms of the niobium (Nb) is 1.3 or more and 1.7 or less when the number of atoms of the above bismuth (Bi) is assumed to be 1. This characteristic composition ratio enables more reliable formation of a crystal phase of the pyrochlore-type crystal structure. Therefore, it should be noted that a crystal phase of the pyrochlore-type crystal structure can be intentionally formed in the above oxide dielectric. Further, the above oxide dielectric not only can show a very high dielectric constant but also can exhibit superior electrical properties (for example, dielectric loss (tan δ)). Consequently, electrical properties of various solid state electronic devices can be improved when the aforementioned oxide dielectric is used therein.

Further, a method of manufacturing an oxide dielectric according to the present invention involves: heating a precursor under an oxygen-containing atmosphere at a first temperature of 520°C to 620°C, the precursor being prepared using a precursor solution as a starting material, the precursor solution containing, as solutes, a precursor containing bismuth (Bi) and a precursor containing niobium (Nb) in which the number of atoms of the above niobium (Nb) is 1.3 or more and 1.7 or less when the number of atoms of the above bismuth (Bi) is assumed to be 1, to form an oxide dielectric consisting essentially of the above bismuth (Bi) and the above niobium (Nb) (possibly including inevitable impurites) and having a crystal phase of the pyrochlore-type crystal structure, in which the number of the above niobium (Nb) is 1.3 or more and 1.7 or less when the number of atoms of the above bismuth (Bi) is assumed to be 1.

According to the above method of manufacturing an oxide dielectric, an oxide dielectric having a crystal phase of the pyrochlore-type crystal structure and capable of showing a very high relative dielectric constant (typically, 220 or more) can be manufactured. As described above, detailed analysis by the present inventors clearly indicates that the relative dielectric constant obtainable from a crystal phase of the pyrochlore-type crystal structure is exceptionally high as compared with that obtainable from a conventional crystal structure (for example, the β-BiNbO₄ crystal structure known in the art). Based on this finding, a precursor can be selected as described above, the precursor being prepared using a precursor solution as a starting material, the precursor solution containing, as solutes, a precursor containing bismuth (Bi) and a precursor containing niobium (Nb) in which the number of atoms of the above niobium (Nb) is 1.3 or more and 1.7 or less when the number of atoms of the above bismuth (Bi) is assumed to be 1. When a precursor having such a composition ratio is used, an oxide dielectric consisting essentially of bismuth (Bi) and niobium (Nb) and having a specific composition rate where the number of atoms of the above niobium (Nb) is 1.3 or more and 1.7 or less when the number of atoms of the above bismuth (Bi) is assumed to be 1 can be more reliably manufactured. Further, use of the above characteristic composition ratio enables more reliable formation of a crystal phase of the pyrochlore-type crystal structure. Therefore, it should be noted that a crystal phase of the pyrochlore-type crystal structure can be intentionally formed according to the above method of manufacturing an oxide dielectric. Further, according to the above method of manufacturing an oxide dielectric, an oxide dielectric can be manufactured which not only can show a very high dielectric constant but also can exhibit superior electrical properties (for example, dielectric loss (tan δ)). Consequently, electrical properties of various solid state electronic devices can be improved when an oxide dielectric manufactured according to the above method of manufacturing an oxide dielectric is used therein.

Further, according to the above method of manufacturing an oxide dielectric, an oxide layer can be formed using a relatively simple, non-photolithographic process (such as the inkjet method, the screen printing method, the intaglio/relief printing method, or the nanoimprinting method). This can eliminate the need to perform a process that takes a relatively long time and/or requires an expensive facility, such as a process using a vacuum. Thus, the above method of manufacturing an oxide layer has superior industrial or mass productivity.

Further, the precursor of an oxide dielectric according to the present invention is a precursor of an oxide consisting essentially of bismuth (Bi) and niobium (Nb) and having a crystal phase of the pyrochlore-type crystal structure, in which the precursor comprises mixed solutes of a precursor containing the above bismuth (Bi) and a precursor containing the above niobium (Nb) in which the number of atoms of the above niobium (Nb) is 1.3 or more and 1.7 or less when the number of atoms of the above bismuth (Bi) is assumed to be 1.

When the above precursor of an oxide dielectric is used, an oxide dielectric consisting essentially of bismuth (Bi) and niobium (Nb) and having a specific composition ratio where the number of atoms of the above niobium (Nb) is 1.3 or more and 1.7 or less when the number of atoms of the above bismuth (Bi) is assumed to be 1 can be manufactured more reliably. Then, use of the above characteristic composition ratio enables more reliable formation of a crystal phase of the pyrochlore-type crystal structure. This indicates that the above precursor of an oxide dielectric is capable of purposefully producing a crystal phase of the pyrochlore-type crystal structure in the oxide dielectric. Moreover, an oxide dielectric formed from the above precursor of an oxide dielectric not only can show a very high dielectric constant but also can exhibit superior electrical properties (for example, dielectric loss (tan δ)). Consequently, by using the above precursor of an oxide dielectric, electrical properties of various solid state electronic devices can be improved when the oxide dielectric manufactured from the above precursor is used therein.

It is noted that the term "under an oxygen-containing atmosphere" as used in the present application means under an oxygen atmosphere or under the air. Further, a value of tan δ is used as a value representing the dielectric loss.

For each aspect of the present invention described above, the mechanism or reason why a crystal phase of the pyrochlore-type crystal structure can be formed in the BNO oxide is not clear at present. However, the present inventors have found that an electrical property which has not been obtained until now can be obtained by virtue of this interesting heterogeneity.

In each aspect of the present invention described above, the oxide may further include an amorphous phase of an oxide including bismuth (Bi) and niobium (Nb). As compared with the case of only an aggregate of microcrystals, the amorphous phase-containing oxide is a preferred mode for reliably preventing degradation or variations in electrical properties, which would otherwise be caused by the formation of unnecessary grain boundaries.

### EFFECT OF INVENTION

An oxide dielectric according to the present invention not only can show a very high relative dielectric constant (typically, 220 or more) as compared with the conventional products but also can exhibit superior electrical properties (for example, dielectric loss (tan δ)), allowing various solid state electronic devices to have improved electrical properties.

Further, according to the method of manufacturing an oxide dielectric of the present invention, an oxide dielectric can be manufactured which not only can show a very high relative dielectric constant (typically, 220 or more) as compared with the conventional products but also can exhibit superior electrical properties (for example, dielectric loss (tan δ)). Moreover, the above method of manufacturing an oxide dielectric has superior industrial or mass productivity.

Furthermore, the precursor of an oxide dielectric according to the present invention enables more reliable formation of a crystal phase of the pyrochlore-type crystal structure in the oxide dielectric. Therefore, when the above precursor of an oxide dielectric is used, an oxide dielectric can be formed which not only can show a very high dielectric constant but also can exhibit superior electrical properties (for example, dielectric loss (tan δ)).

### BRIEF DESCRIPTION OF THE DRAWINGS

Fig. 1 is a view showing the overall structure of a thin film capacitor as an example of a solid state electronic device in First Embodiment of the present invention.
Fig. 2 shows observation results of the cross-sectional TEM (Transmission Electron Microscopy) image and electron diffraction images of the thin film capacitor according to First Embodiment of the present invention.
Fig. 3 is a cross-sectional schematic view showing a process in the method for manufacturing the thin film capacitor in First Embodiment of the present invention.
Fig. 4 is a cross-sectional schematic view showing a process in the method for manufacturing the thin film capacitor in First Embodiment of the present invention.
Fig. 5 is a cross-sectional schematic view showing a process in the method for manufacturing the thin film capacitor in First Embodiment of the present invention.
Fig. 6 is a cross-sectional schematic view showing a process in the method for manufacturing the thin film capacitor in First Embodiment of the present invention.
Fig. 7 shows a graph of the relative dielectric constant and dielectric loss (tan δ) of an oxide layer formed by preparing a precursor solution so that the number of atoms of niobium (Nb) was 1.5 when the number of atoms of bismuth (Bi) was assumed to be 1, and heating at 550°C according to First Embodiment of the present invention.
Fig 8. shows a graph similar to Fig. 6 when an oxide layer was formed by preparing a precursor solution so that the number of atoms of niobium (Nb) was 1.5 when the number of atoms of bismuth (Bi) was assumed to be 1, and heating at 600°C according to First Embodiment of the present invention.
Fig 9. shows results from X-ray diffraction (XRD) measurements, which are indicative of crystal structures, of an oxide layer formed by preparing a precursor solution so that the number of atoms of niobium (Nb) was 1.5 when the number of atoms of bismuth (Bi) was assumed to be 1, and heating at 550°C or 600°C according to First Embodiment of the present invention.
Fig. 10 shows results from X-ray diffraction (XRD) measurements, which are indicative of crystal structures, of an oxide layer formed by preparing a precursor solution so that the number of atoms of niobium (Nb) was 1 when the number of atoms of bismuth (Bi) was assumed to be 1, and heating at 550°C or 600°C.
Fig. 11 is a view showing the overall structure of a thin film capacitor as an example of solid state electronic devices in Second Embodiment of the present invention.
Fig. 12 is a view showing the overall structure of a thin film capacitor as an example of solid state electronic devices in Third Embodiment of the present invention.
Fig. 13 is a cross-sectional schematic view showing a process in the method for manufacturing a thin film capacitor according to Third Embodiment of the present invention.
Fig. 14 is a cross-sectional schematic view showing a process in the method for manufacturing a thin film capacitor according to Third Embodiment of the present invention.
Fig. 15 is a cross-sectional schematic view showing a process in the method for manufacturing a thin film capacitor according to Third Embodiment of the present invention.
Fig. 16 is a cross-sectional schematic view showing a process in the method for manufacturing a thin film capacitor according to Third Embodiment of the present invention.
Fig. 17 is a cross-sectional schematic view showing a process in the method for manufacturing a thin film capacitor according to Third Embodiment of the present invention.
Fig. 18 is a cross-sectional schematic view showing a process in the method for manufacturing a thin film capacitor according to Third Embodiment of the present invention.
Fig. 19 is a cross-sectional schematic view showing a process in the method for manufacturing a thin film capacitor according to Third Embodiment of the present invention.
Fig. 20 is a cross-sectional schematic view showing a process in the method for manufacturing a thin film capacitor according to Third Embodiment of the present invention.
Fig. 21 is a cross-sectional schematic view showing a process in the method for manufacturing a thin film capacitor according to Third Embodiment of the present invention.
Fig. 22 is a cross-sectional schematic view showing a process in the method for manufacturing a thin film capacitor according to Third Embodiment of the present invention.
Fig. 23 is a cross-sectional schematic view showing a process in the method for manufacturing a thin film capacitor according to Fourth Embodiment of the present invention.
Fig. 24 is a cross-sectional schematic view showing a process in the method for manufacturing a thin film capacitor according to Fourth Embodiment of the present invention.
Fig. 25 is a cross-sectional schematic view showing a process in the method for manufacturing a thin film capacitor according to Fourth Embodiment of the present invention.
Fig. 26 is a view showing the overall structure of a thin film capacitor as an example of solid state electronic devices in Fourth Embodiment of the present invention.

### EMBODIMENTS OF THE INVENTION

A solid state electronic device according to an embodiment of the present invention will be described with reference to the attached drawings. For the description, common reference signs are attached to common parts throughout the drawings, unless otherwise stated. In the drawings, elements of the embodiments are not always shown to scale. Some of the reference signs may also be omitted for clear view of each drawing.

### <First Embodiment>

### 1. Overall structure of thin film capacitor of this embodiment

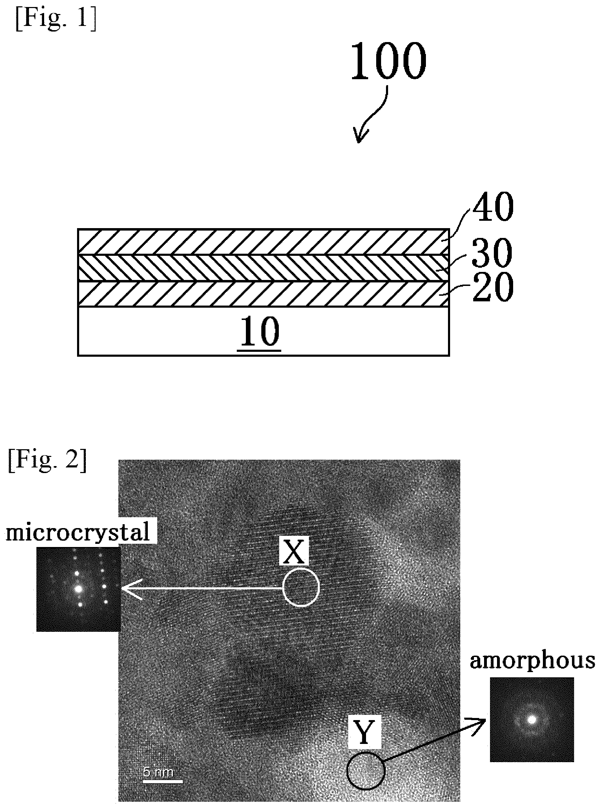

Fig. 1 is a view showing the overall structure of a thin film capacitor 100 as an example of the solid state electronic device according to this embodiment. As shown in Fig. 1, the thin film capacitor 100 includes a lower electrode layer 20, an oxide dielectric layer (hereinafter, it is also abbreviated as an "oxide layer," and the same applies hereinafter) 30, and an upper electrode layer 40, which are formed on a substrate 10 and arranged in order from the substrate 10 side.

The substrate 10 may be, for example, any of various insulating materials, including highly heat-resistant glass, a SiO₂/Si substrate, an alumina (Al₂O₃) substrate, an STO (SrTiO) substrate, an insulating substrate and the like having an STO (SrTiO) layer formed via a SiO2 layer and a Ti layer at the surface of a Si substrate), and a semiconductor substrate (such as a Si substrate, a SiC substrate, or a Ge substrate).

The lower electrode layer 20 and the upper electrode layer 40 may each be made of a metallic material such as a high-melting-point metal such as platinum, gold, silver, copper, aluminum, molybdenum, palladium, ruthenium, iridium, or tungsten, or any alloy thereof.

In this embodiment, the oxide dielectric layer (oxide layer 30) is formed by a process that includes providing, as a starting material, a precursor solution containing a bismuth (Bi)-containing precursor and a niobium (Nb)-containing precursor as solutes; and heating the precursors in an oxygen-containing atmosphere (hereinafter, the manufacturing method using this process will also be referred to as the "solution process"). It is noted that the number of atoms of bismuth (Bi) and the number of atoms of niobium (Nb) as solutes in the precursor solution according to this embodiment are adjusted such that the number of atoms of niobium (Nb) is 1.3 or more and 1.7 or less (typically 1.5) when the number of atoms of bismuth (Bi) in the above precursor containing bismuth (Bi) is assumed to be 1.

The oxide layer 30 consisting essentially of bismuth (Bi) and niobium (Nb) can be obtained using a layer of a precursor prepared from the aforementioned precursor solution as a starting material (also simply referred to as the "precursor layer"). More specifically, the oxide layer 30 according to this embodiment contains an oxide consisting essentially of bismuth (Bi) and niobium (Nb) and having a crystal phase of the pyrochlore-type crystal structure (including a fine crystal phase). Moreover, in the above oxide layer 30, the number of atoms of niobium (Nb) is 1.3 or more and 1.7 or less when the number of atoms of bismuth (Bi) is assumed to be 1.

Fig. 2 shows an observation using the cross-sectional TEM (Transmission Electron Microscopy) image and electron diffraction images of a BNO oxide layer (oxide layer 30). The Miller index and the interatomic distance were obtained using the electron diffraction image of the BNO oxide layer, and fitted to known crystal structure models to perform structure analysis. As the known crystal structure models, used were (Bi₁.₅Zn_{0.5})(Zn_{0.5}Nb₁.₅)O₇, β-BiNbO₄, and Bi₃NbO₇. As shown in Fig. 2, results reveal that the crystal phase of the pyrochlore-type crystal structure in the oxide layer 30 according to this embodiment is of the (Bi_{1.5}Zn_{0.5})(Zn_{0.5}Nb_{1.5})O₇-type structure, or is substantially the same as or similar to the (Bi_{1.5}Zn_{0.5})(Zn_{0.5}Nb_{1.5})O₇-type structure.

It is noted that the pyrochlore-type crystal structure known to date can be formed as a result of inclusion of "zinc," but a result different from the known aspects was obtained in this embodiment. Why the pyrochlore-type crystal structure can be formed in a zinc-free composition is not clear at present. However, as described below, formation of a crystal phase of the pyrochlore-type crystal structure can confer good dielectric properties (in particular, a high relative dielectric constant) on dielectric layers of thin film capacitors or insulting layers of other various solid state electronic devices (for example, semiconductor devices or microelectromechanical systems).

Further, as shown in Fig. 2, the oxide layer 30 according to this embodiment also has an amorphous phase of an oxide consisting essentially of bismuth (Bi) and niobium (Nb). The coexistence of the crystal phase and the amorphous phase as described above is a preferred aspect in view of reliably preventing deteriorated or varied electrical properties due to unwanted formation of grain boundary.

It is noted that this embodiment shall not be limited to the above structure. Further, in view of clarity in drawings, descriptions are omitted for patterning of a withdrawal electrode layer from each electrode layer.

### 2. Method of manufacturing thin film capacitor 100

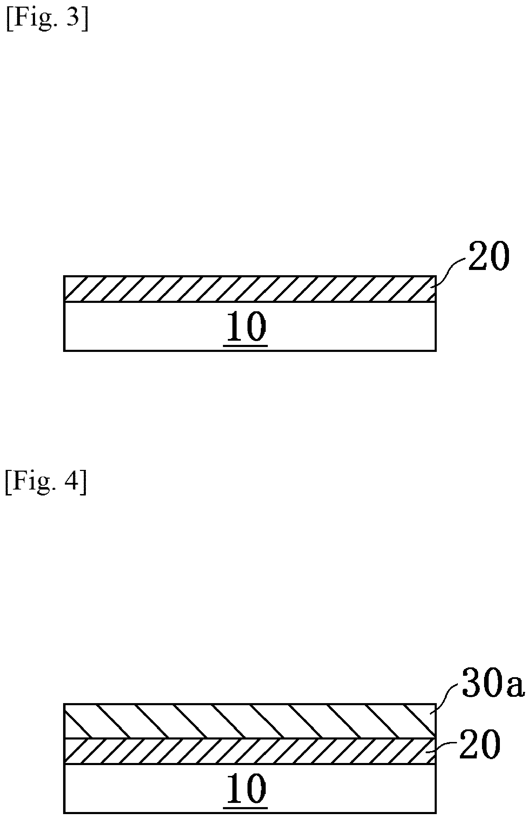

Next, a method of manufacturing a thin film capacitor 100 will be described. It is noted that the temperature indicated in the present application represents a temperature set for a heater. Figs. 3 to 6 are cross-sectional schematic views each illustrating a step in the method of manufacturing the thin film capacitor 100. As shown in Fig. 3, the lower electrode layer 20 is first formed on the substrate 10. Next, the oxide layer 30 is formed on the lower electrode layer 20, and the upper electrode layer 40 is then formed on the oxide layer 30.

### (1) Formation of lower electrode layer

Fig. 3 is a view showing the step of forming the lower electrode layer 20. This embodiment provides an example where the lower electrode layer 20 of the thin film capacitor 100 is made of platinum (Pt). As the lower electrode layer 20, a platinum (Pt) layer is formed on the substrate 10 by a known sputtering method.

### (2) Formation of oxide layer as insulting layer

Subsequently, the oxide layer 30 is formed on the lower electrode layer 20. The oxide layer 30 is formed by sequentially performing the steps of (a) forming a precursor layer and then subjecting the precursor layer to preliminary annealing, and (b) subjecting the preliminarily-annealed layer to main annealing. Figs. 4 to 6 are views showing the process of forming the oxide layer 30. This embodiment provides an example where the oxide layer 30 in the process of manufacturing the thin film capacitor 100 is formed from an oxide consisting essentially of bismuth (Bi) and niobium (Nb) and having a crystal phase of the pyrochlore-type crystal structure.

### (a) Formation of precursor layer and preliminary annealing

As shown in Fig. 4, a precursor layer 30a prepared using a precursor solution as a starting material is formed on the lower electrode layer 20 by a known spin coating method, the precursor solution including a precursor containing bismuth (Bi) and a precursor containing niobium (Nb) as solutes (which is referred to as the precursor solution. Hereinafter, the same applies to a solution of precursors). In this embodiment, examples of the precursor containing bismuth (Bi) for the oxide layer 30 can include bismuth 2-ethylhexanoate, bismuth octylate, bismuth chloride, bismuth nitrate, or various bismuth alkoxides (e.g., bismuth isopropoxide, bismuth butoxide, bismuth ethoxide, and bismuth methoxyethoxide). Further, in this embodiment, examples of the precursor containing niobium (Nb) for the oxide layer 30 can include niobium 2-ethylhexanoate, niobium octylate, niobium chloride, niobium nitrate, or various niobium alkoxides (e.g., niobium isopropoxide, niobium butoxide, niobium ethoxide, and niobium methoxyethoxide). Further, the solvent in the precursor solution is preferably at least one alcohol solvent selected from the group consisting of ethanol, propanol, butanol, 2-methoxyethanol, 2-ethoxyethanol, and 2-butoxyethanol, or at least one carboxylic acid solvent selected from the group consisting of acetic acid, propionic acid, and octylic acid. In a mode, therefore, the solvent of the precursor solution may also be a mixed solvent of two or more of the above alcohol or carboxylic acid solvents.

Further, in this embodiment, a precursor solution including precursors shown in (1) and (2) below as solutes in which the number of atoms of bismuth (Bi) and the number of atoms of niobium (Nb) are adjusted is used as a starting material:
(1) a precursor containing the above bismuth (Bi),
(2) a precursor containing niobium (Nb) in which the number of atoms of niobium (Nb) is 1.3 or more and 1.7 or less when the number of atoms of bismuth (Bi) in the precursor (1) is assumed to be 1.

Subsequently, preliminary annealing is performed under an oxygen atmosphere or under the air (may be referred to as "under an oxygen-containing atmosphere" collectively) at a temperature in the range of 80°C or more and 250°C or less for a certain period of time. In the preliminary annealing, the solvent in the precursor layer 30a is sufficiently evaporated to form a preferred gel state (before thermal decomposition, and organic chains are likely to remain) to provide properties for enabling subsequent plastic deformation. To achieve this effect more reliably, the preliminary annealing temperature is preferably 80°C or more and 250°C or less. Moreover, the formation of the precursor layer 30a by the spin coating method and the preliminary annealing may be repeated a plurality of times, so that the oxide layer 30 can be formed with a desired thickness.

### (b) Main annealing

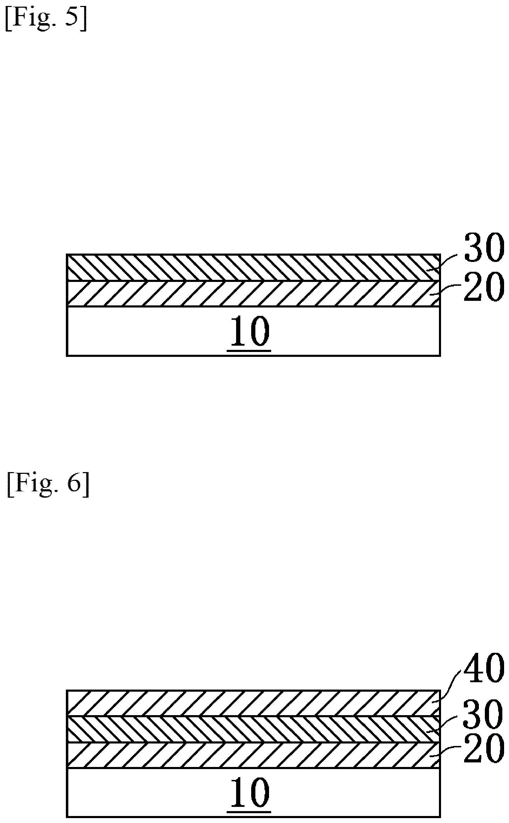

In the main annealing, the precursor layer 30a is then heated under an oxygen atmosphere (which is typically, but not limited to, 100% by volume of oxygen) at a temperature in the range of 520°C or more and 620°C or less (the first temperature) for a certain period of time. As a result, the oxide layer 30 consisting essentially of bismuth (Bi) and niobium (Nb) is formed on an electrode layer as shown in Fig. 5. It is noted that the atomic composition ratio of bismuth (Bi) and niobium (Nb) in the above oxide layer 30 is such that niobium (Nb) is 1.3 or more and 1.7 or less when (Bi) is assumed to be 1.

Here, in this embodiment, the temperature (the first temperature) in the main annealing is 520°C or more and 620°C or less. However, the upper limit thereof merely represents a temperature at which an effect of this embodiment as described below is confirmed to be achieved, but does not represent a technical limit for achieving the effect.

Nonetheless, our research and analysis indicate that, for example, in a case where the precursor solution is prepared so that the number of atoms of niobium (Nb) is 1 when the number of atoms of bismuth (Bi) is assumed to be 1, crystal phases of the pyrochlore-type crystal structure were less observed while β-BiNbO4 crystal structures are more observed as the temperature increased toward 600°C from 550°C upon heating the precursor layer. However, in a case where the precursor layer 30a according to this embodiment was used, very interesting results were obtained: β-BiNbO₄ crystal structures were less observed even when heated at 600°C or more; in other words, crystal phases of the pyrochlore-type crystal structure reliably remained. This represents a notable effect of the precursor layer 30a according to this embodiment in which a crystal phase of the pyrochlore-type crystal structure can be maintained even at a high temperature of 600°C or more.

In this regard, the thickness of the oxide layer 30 is preferably in the range of 30 nm or more. If the thickness of the oxide layer 30 is decreased to less than 30 nm, leakage current and dielectric loss can increase due to the decrease in the thickness, which is not practical for solid state electronic device applications and thus is not preferred.

### (3) Formation of upper electrode layer

Subsequently, the upper electrode layer 40 is formed on the oxide layer 30. Fig. 6 is a view showing the step of forming the upper electrode layer 40. This embodiment provides an example where the upper electrode layer 40 of the thin film capacitor 100 is made of platinum (Pt). For the upper electrode layer 40, a platinum (Pt) layer is formed on the oxide layer 30 by a known sputtering method as in the case of the lower electrode layer 20. The thin film capacitor 100 shown in Fig. 1 is obtained after the formation of the upper electrode layer 40.

In this embodiment, formed is an oxide layer consisting essentially of bismuth (Bi) and niobium (Nb) which is formed by heating a precursor layer under an oxygen-containing atmosphere, the precursor layer being prepared using a precursor solution as a starting material, the precursor solution including a precursor containing bismuth (Bi) and a precursor containing niobium (Nb) as solutes. Further, good electrical properties can be obtained in particular when the heating temperature for forming the above oxide layer is 520°C or more. It is noted that good electrical properties may be obtained even when the heating temperature is more than 600°C (for example, 620°C or less). In particular, as the ratio of niobium (Nb) relative to bismuth (Bi) increases, a crystal phase of the pyrochlore-type crystal structure tends to remain reliably even when the heating temperature is even higher.

In addition, when the method according to this embodiment is used to form the oxide layer, the precursor solution for the oxide layer is simply heated in an oxygen-containing atmosphere without using any vacuum process, which makes it easy to perform large-area fabrication as compared to conventional sputtering and also makes it possible to significantly increase the industrial or mass productivity.

### 3. Electrical properties of thin film capacitor 100

### (1) Relative dielectric constant and dielectric loss (tan δ)

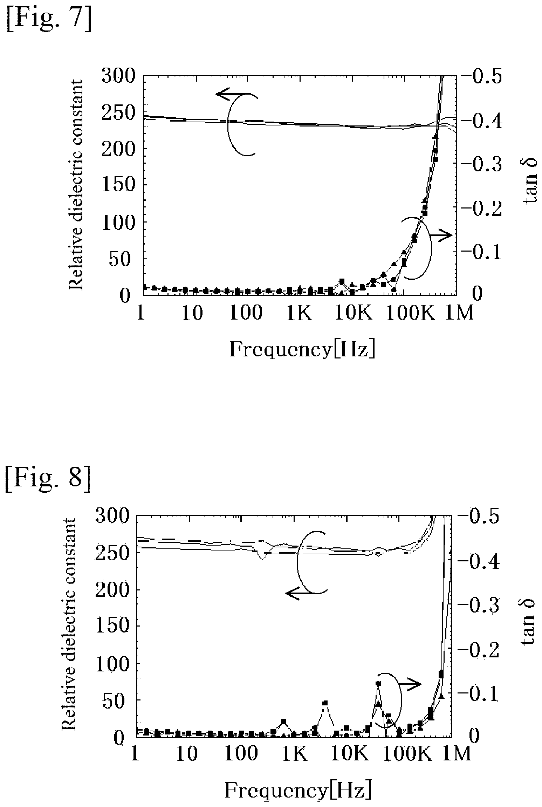

Fig. 7 is a graph showing the relative dielectric constant and dielectric loss (tan δ) of the oxide layer 30 formed by heating at 550°C according to this embodiment. Similarly in Fig. 7, Fig. 8 is also a graph for the oxide layer 30 formed by heating at 600°C according to this embodiment.

It is noted that the relative dielectric constant was measured by applying an alternating-current voltage of 1 kHz with a voltage of 0.1 V between the lower electrode layer and the upper electrode layer. A 1260-SYS broadband dielectric measurement system from TOYO Corp. was used for the measurements. Further, dielectric loss (tan δ) was measured at room temperature by applying an alternating-current voltage of 1 kHz with a voltage of 0.1 V between the lower electrode layer and the upper electrode layer. A 1260-SYS broadband dielectric measurement system from TOYO Corp. was used for the measurements.

More specifically, Fig. 7 shows the relative dielectric constant and dielectric loss (tan δ) of the oxide layer 30 at a frequency of 1 Hz to 1 MHz when the oxide layer was formed by preparing the precursor solution so that the number of atoms of niobium (Nb) was 1.5 when the number of atoms of bismuth (Bi) was assumed to be 1, and heating at 550°C. Further, Fig. 8 shows the relative dielectric constant and dielectric loss (tan δ) of the oxide layer 30 at a frequency of 1 Hz to 1 MHz when the oxide layer was formed by preparing the precursor solution so that the number of atoms of niobium (Nb) was 1.5 when the number of atoms of bismuth (Bi) was assumed to be 1, and heating at 600°C. It is noted that in both Figs. 7 and 8, three similar samples for each case were used to measure the dielectric constant and dielectric loss (tan δ) in order to evaluate reproducibility.

As shown in Fig. 7 and 8, the relative dielectric constant was 220 or more at any frequencies from 1 Hz to 1 MHz. In particular, it should be noted that the oxide layer 30 formed by heating at 600°C showed a higher dielectric constant (about 250 or more) than the oxide layer 30 formed by heating at 550°C at any of the above frequencies. Meanwhile, with regard to dielectric loss (tan δ), the oxide layer 30 formed by heating at 600°C showed somewhat varied values of dielectric loss (tan δ). Nonetheless, good results were obtained regardless of the heating temperature. It is noted that dominance of parasitic inductance due to the structural nature of the thin film capacitor 100 may explain why the dielectric loss (tan δ) showed a sharp increase in its values at the high frequency region (20 kHz or more). In other words, it may no longer represent the properties of the BNO oxide itself at the high frequency region (20 kHz or more).

It is noted that values of the relative dielectric constant shown in Figs. 7 and 8 are for the entire oxide layer. As described below, our analysis finds that the values of the dielectric constant for an entire oxide layer consisting essentially of bismuth (Bi) and niobium (Nb) can be varied when the oxide layer has a crystal phase (for example, a crystal phase of the β-BiNbO₄-type crystal structure) other than a crystal phase of the pyrochlore-type crystal structure and/or an amorphous phase. However, as shown in Figs. 7 and 8, the oxide layer 30 according to this embodiment appears to have many crystal phases of the pyrochlore-type crystal structure which are presumably responsible for a high relative dielectric constant. In other words, Figs. 7 and 8 show that a crystal phase of the pyrochlore-type crystal structure can be maintained even after annealing at a temperature as high as 600°C.

Note that, as Comparative Example, the relative dielectric constant and dielectric loss (tan δ) of the oxide layer 30 at a frequency of 1 Hz to 1 MHz were further investigated in a case where the oxide layer was formed by preparing the precursor solution so that the number of atoms of niobium (Nb) was 1.5 when the number of atoms of bismuth (Bi) was assumed to be 1, and heating at 500°C. The results indicated that the relative dielectric constant and dielectric loss both showed very large frequency dependence. In particular, with regard to the relative dielectric constant, the results showed that the value at 1 Hz was about 250 while the value at 1 MHz was decreased to about 60. Here, the oxide formed by heating at 500°C was largely composed of amorphous phases. This suggests that these amorphous phases at 500°C had significant impacts on electrical properties. In other words, electrical properties are dominated by the amorphous phases. This appears to be responsible for very large frequency dependence. It is noted that the relative dielectric constant and dielectric loss (tan δ) of the oxide layer 30 would approach the properties of an oxide formed by heating at 550°C if heating were performed at 520°C or more at which crystallization is promoted, and a crystal phase of the pyrochlore-type crystal structure is more reliably formed.

### (2) Leakage current

A value of leakage current when the voltage was applied at 50 kV/cm was investigated for the oxide layer 30 formed by preparing the precursor solution so that the number of atoms of niobium (Nb) was 1.5 when the number of atoms of bismuth (Bi) was take as 1, and heating at 550°C. Results showed that a value of leakage current capable of providing satisfactory properties for capacitors was able to be obtained. The leakage current was measured with the voltage applied between the lower and upper electrode layers. The measurement was also performed using Model 4156C manufactured by Agilent Technologies, Inc.

### 3. Analysis of crystal structure by X-ray diffraction (XRD) method

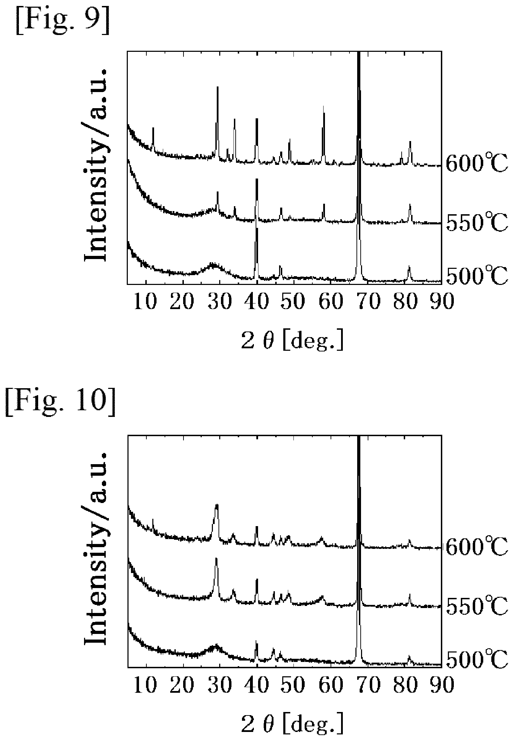

Fig. 9 shows results from X-ray diffraction (XRD) measurements, which are indicative of crystal structures, of the oxide layer 30 formed by preparing a precursor solution so that the number of atoms of niobium (Nb) was 1.5 when the number of atoms of bismuth (Bi) was assumed to be 1, and heating at 550°C or 600°C. Fig. 10 shows results from X-ray diffraction (XRD) measurements, which are indicative of crystal structures, of an oxide layer formed by preparing a precursor solution so that the number of atoms of niobium (Nb) was 1 when the number of atoms of bismuth (Bi) was assumed to be 1, and heating at 550°C or 650°C. It is noted that each figure also shows the measurement results of an oxide layer as Comparative Example formed by preparing a precursor solution so that the number of atoms of niobium (Nb) was 1.5 when the number of atoms of bismuth (Bi) was assumed to be 1, and heating at 500°C.

As shown in Figs. 9 and 10, the results show that the half-widths around a 2θ of 28° to 29° were smaller for the precursor solutions prepared so that the number of atoms of niobium (Nb) was 1.5 when the number of atoms of bismuth (Bi) was assumed to be 1, as compared with the precursor solutions prepared so that the number of atoms of niobium (Nb) was 1 when the number of atoms of bismuth (Bi) was assumed to be 1. Further, the peak around 28° to 29° described above is indicative of the pyrochlore-type crystal structure. Therefore, this indicates that a crystal phase of the pyrochlore-type crystal structure had been grown in a case where a precursor solution was used which was prepared so that the number of niobium (Nb) atom was 1.5 when the number of atoms of bismuth (Bi) was assumed to be 1. On the other hand, Comparative Example shown in each figure only showed a broad peak around a 2θ of 28° to 29° when heated at 500°C. This suggests that little or no crystal phase of the pyrochlore-type crystal structure was likely formed in the oxide layers heated at 500°C.

It is noted that each of the analysis or measurements described above was performed for the oxide layer 30 formed from the precursor solution prepared so that the number of atoms of niobium (Nb) was 1.5 when the number of atoms of bismuth (Bi) was assumed to be 1. However, results essentially equivalent to those of the analysis or measurements described above can be obtained for the oxide layer 30 formed from a precursor solution prepared so that the number of atoms of niobium (Nb) is 1.3 or more and 1.7 or less when the number of atoms of bismuth (Bi) is assumed to be 1.

Further, good electrical properties can be obtained when the oxide layer 30 finally formed is an oxide dielectric consisting essentially of bismuth (Bi) and niobium (Nb) (possibly including inevitable impurites) and having a crystal phase of the pyrochlore-type crystal structure in which the number of atoms of the above niobium (Nb) is 1.3 or more and 1.7 or less when the number of atoms of the above bismuth (Bi) is assumed to be 1.

As described above, the results indicate that the relative dielectric constant and dielectric loss (tan δ) as well as the leakage current value are particularly preferred for use in various solid state electronic devices (for example, capacitors, semiconductor devices, or microelectromechanical systems, or alternatively composite devices including at least two of a high pass filter, a patch antenna, or RCL) when the atomic composition ratio of bismuth (Bi) and niobium (Nb) in the oxide layer 30 is such that the number of atoms of the above niobium (Nb) is 1.3 or more and 1.7 or less when the number of atoms of bismuth (Bi) is assumed to be 1.

### <Second embodiment>

A thin film capacitor 200 according to this embodiment is the same as the thin film capacitor 100 according to First Embodiment except that the oxide layer 30 of the thin film capacitor 100 formed in First Embodiment is replaced by an oxide layer 230. Therefore, repeated description of the same part as in First Embodiment will be omitted.

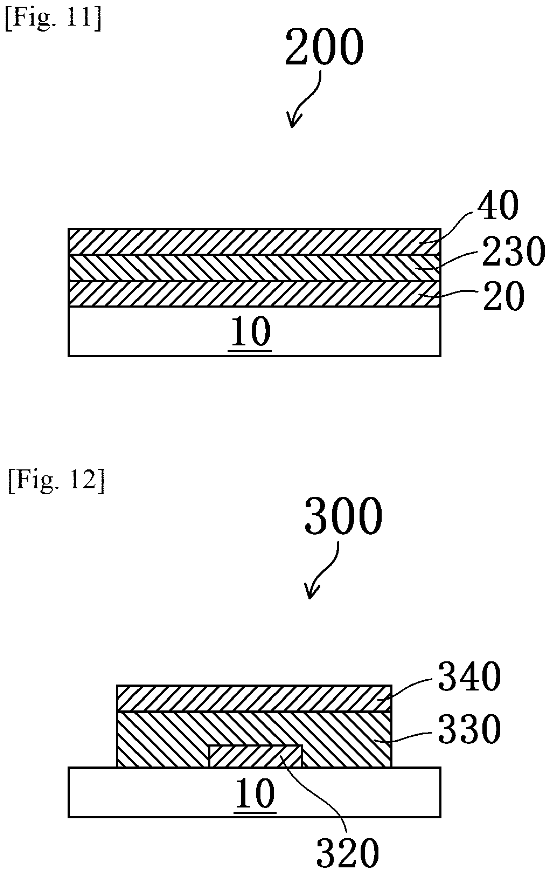

Fig. 11 is a view showing the overall configuration of the thin film capacitor 200 as an example of solid state electronic devices according to this embodiment. The oxide layer 230 according to this embodiment is formed by forming the oxide layer 30 according to First Embodiment at the first temperature (520°C or more and 620°C or less) in the main annealing step, and then further heating for about 20 minutes under an oxygen-containing atmosphere at a second temperature (typically 350°C to 600°C) which is equal to or lower than the first temperature. In this embodiment, heating of the oxide layer at the second temperature as described above may also be referred to as the "post-annealing treatment."

The thin film capacitor 200 having the oxide layer 230 as described above can provide an effect for further enhancing adhesion of the oxide layer 230 with an underlying layer thereof (namely, the lower electrode layer 20) and/or the upper electrode layer 40 without substantially altering the relative dielectric constant of the thin film capacitor 100 according to First Embodiment.

It is noted that the second temperature in the post-annealing treatment is preferably equal to or lower than the first temperature. This is because the second temperature will likely affect the physical properties of the oxide layer 230 if the second temperature is higher than the first temperature. Therefore, the temperature is preferably selected so that the second temperature will not be a dominant factor to determine the physical properties of the oxide layer 230. Meanwhile, the lower limit of the second temperature in the post-annealing treatment will be selected in view of enhanced adhesion with an underlying layer (namely, the lower electrode layer 20) and/or the upper electrode layer 40 as described above.

### <Third Embodiment>

### 1. Overall structure of thin film capacitor of this embodiment

In this embodiment, imprinting is performed in the process of forming all layers of a thin film capacitor as an example of the solid state electronic device. Fig. 12 shows the overall structure of a thin film capacitor 300 as an example of the solid state electronic device according to this embodiment. This embodiment is the same as First Embodiment, except that the lower electrode layer, the oxide layer, and the upper electrode layer are subjected to imprinting. Note that repeated description of the same part as in First Embodiment will be omitted.

As shown in Fig. 12, the thin film capacitor 300 of this embodiment is formed on a substrate 10 as in First Embodiment. The thin film capacitor 300 includes a lower electrode 320, an oxide layer 330 including an oxide dielectric, and an upper electrode layer 340 in this order from the substrate 10.

### 2. Process of manufacturing thin film capacitor 300

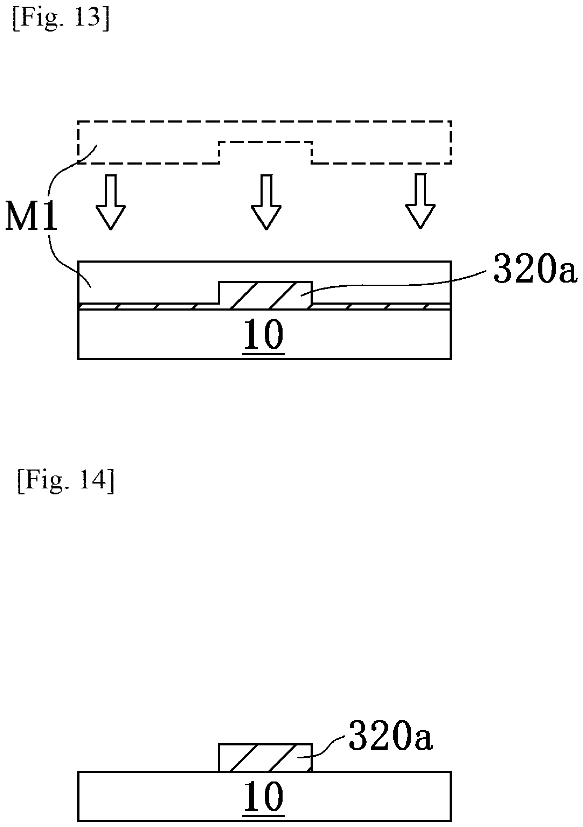

Next, a method for manufacturing the thin film capacitor 300 will be described. Figs. 13 to 22 are cross-sectional schematic views each showing a process in the method for manufacturing the thin film capacitor 300. In the manufacture of the thin film capacitor 300, an imprinted lower electrode layer 320 is first formed on the substrate 10. An imprinted oxide layer 330 is then formed on the lower electrode layer 320. An imprinted oxide layer 330 is then formed on the lower electrode layer 320. Subsequently, an imprinted upper electrode layer 340 is formed on the oxide layer 330. Repeated description of the same part of the process of manufacturing the thin film capacitor 300 as in First Embodiment will also be omitted.

### (1) Formation of lower electrode layer

This embodiment provides an example where the lower electrode layer 320 of the thin film capacitor 300 is made of a conductive oxide layer including lanthanum (La) and nickel (Ni). The lower electrode layer 320 is formed by sequentially performing the steps of (a) forming a precursor layer and then subjecting the precursor layer to preliminary annealing, (b) subjecting the preliminarily-annealed layer to imprinting, and (c) subjecting the imprinted layer to main annealing.

### (a) Formation of precursor layer and step of preliminary annealing

First, a precursor layer 320a for a lower electrode layer is formed on the substrate 10 by a known spin coating method using, as a starting material, a lower electrode layer-forming precursor solution containing a lanthanum (La)-containing precursor and a nickel (Ni)-containing precursor as solutes.

Subsequently, preliminary annealing is performed, in which the precursor layer 320a for a lower electrode layer is heated in the temperature range of 80°C or more and 250°C or less for a certain period of time in an oxygen-containing atmosphere. The formation of the precursor layer 320a for a lower electrode layer by spin coating and the preliminary annealing may also be repeated a plurality of times, so that the lower electrode layer 320 can be formed with a desired thickness.

### (b) Imprinting

As shown in Fig. 13, the precursor layer 320a for a lower electrode layer is then patterned by imprinting at a pressure of 1 MPa or more and 20 MPa or less using a lower electrode layer-forming mold M1 while it is heated in the range of 80°C or more and 300°C or less. Examples of the heating method during the imprinting include a method of maintaining an atmosphere at a certain temperature in a chamber, an oven, or other means, a method of heating, with a heater, a lower part of a mount on which the substrate is mounted, and a method of performing imprinting using a mold heated in advance at 80°C or more and 300°C or less. In this case, in view of workability, the method of heating a lower part of a mount with a heater is more preferably used in combination with a mold pre-heated at 80°C or more and 300°C or less.

In this case, the mold heating temperature is set at 80°C or more and 300°C or less for the following reason. If the heating temperature during the imprinting is less than 80°C, the ability to plastically deform the precursor layer 320a for a lower electrode layer will decrease due to the reduced temperature of the precursor layer 320a for a lower electrode layer, so that the ability to form an imprinted structure will decrease or the reliability or stability after the forming will decrease. If the heating temperature during the imprinting is more than 300°C, the decomposition (oxidative pyrolysis) of organic chains as a source of plastic deformability can proceed, so that the plastic deformation ability can decrease. From the above points of view, it is a more preferred mode to heat the precursor layer 320a for a lower electrode layer in the range of 100°C or more and 250°C or less during the imprinting.

The pressure during the imprinting should be in the range of 1 MPa or more and 20 MPa or less, so that the precursor layer 320a for a lower electrode layer can be deformed so as to follow the surface shape of the mold, which makes it possible to form a desired imprinted structure with high precision. The pressure applied during the imprinting should also be set in a low range, such as 1 MPa or more and 20 MPa or less. This makes the mold less likely to be damaged during the imprinting and is also advantageous for large-area fabrication.

The entire surface of the precursor layer 320a for a lower electrode layer is then subjected to etching. As a result, as shown in Fig. 14, the precursor layer 320a for a lower electrode layer is completely removed from a region other than the region corresponding to a lower electrode layer (the step of subjecting the entire surface of the precursor layer 320a for a lower electrode layer to etching).

In addition, the imprinting process preferably includes previously performing a release treatment on the surface of each precursor layer, which is to be in contact with the imprinting surface, and/or previously performing a release treatment on the imprinting surface of the mold, and then imprinting each precursor layer. Such a treatment is performed. As a result, the friction force between each precursor layer and the mold can be reduced, so that each precursor layer can be subjected to imprinting with higher precision. Examples of a release agent that may be used in the release treatment include surfactants (such as fluoro-surfactants, silicone surfactants, and nonionic surfactants), and fluorine-containing diamond-like carbon materials.

### (c) Main annealing

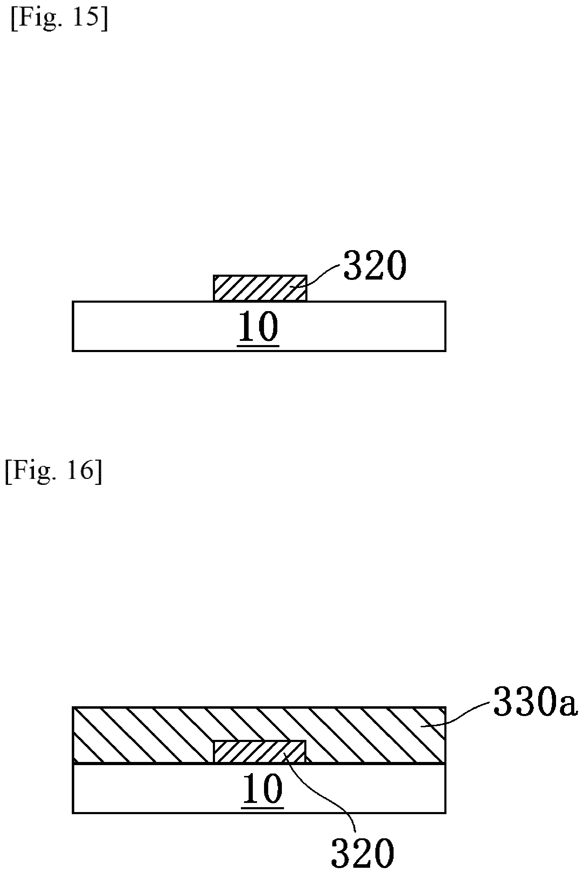

The precursor layer 320a for a lower electrode layer is then subjected to main annealing in the air. During the main annealing, the heating temperature is 550°C or more and 650°C or less. As a result, as shown in Fig. 15, a lower electrode layer 320 (note that it possibly includes inevitable impurities; the same applies hereinafter) consisting essentially of lanthanum (La) and nickel (Ni) is formed on the substrate 10.

### (2) Formation of oxide layer serving as dielectric or insulating layer

An oxide layer 330 as a dielectric layer is then formed on the lower electrode layer 320. The oxide layer 330 is formed by sequentially performing the steps of (a) forming a precursor layer and then subjecting the precursor layer to preliminary annealing, (b) subjecting the preliminarily-annealed layer to imprinting, and (c) subjecting the imprinted layer to main annealing. Figs. 16 to 19 are views showing the process of forming the oxide layer 330.

### (a) Formation of oxide precursor layer and preliminary annealing

As shown in Fig. 16, a precursor layer 330a is formed on the substrate 10 and the patterned lower electrode layer 320 using, as a starting material, a precursor solution containing a bismuth (Bi)-containing precursor and a niobium (Nb)-containing precursor as solutes, as in Second Embodiment. In this embodiment, preliminary annealing is then performed by heating at 80°C or more and 250°C or less in an oxygen-containing atmosphere. It is noted that as in First Embodiment, the number of atoms of bismuth (Bi) and the number of atoms of niobium (Nb) as solutes in the precursor solution according to this embodiment are adjusted such that the number of atoms of niobium (Nb) is 1.3 or more and 1.7 or less (typically 1.5) when the number of atoms of bismuth (Bi) in the above precursor containing bismuth (Bi) is assumed to be 1.

### (b) Imprinting

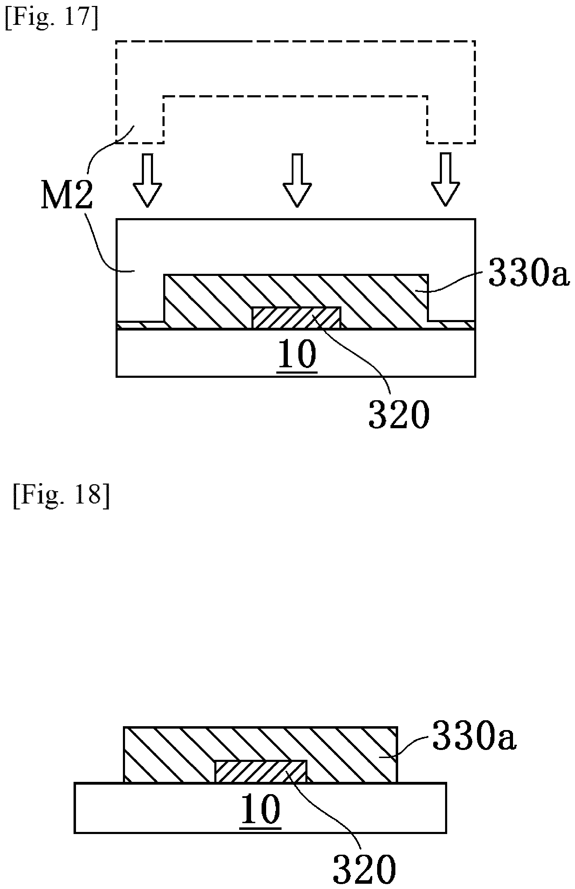

In this embodiment, as shown in Fig. 17, the precursor layer 330a having undergone only the preliminary annealing is subjected to imprinting. Specifically, the precursor layer 330a is imprinted at a pressure of 1 MPa or more and 20 MPa or less using a dielectric layer-forming mold M2 for oxide layer pattering while it is heated at 80°C or more and 300°C or less.

Subsequently, the entire surface of the precursor layer 330a is subjected to etching. As a result, as shown in Fig. 18, the precursor layer 330a is completely removed from a region other than the region corresponding to an oxide layer 330 (the step of subjecting the entire surface of the precursor layer 330a to etching). In this embodiment, the step of etching the precursor layer 330a is preformed using a wet etching technique without any vacuum process. However, etching by a so-called dry etching technique using plasma shall not be precluded.

### (c) Main annealing

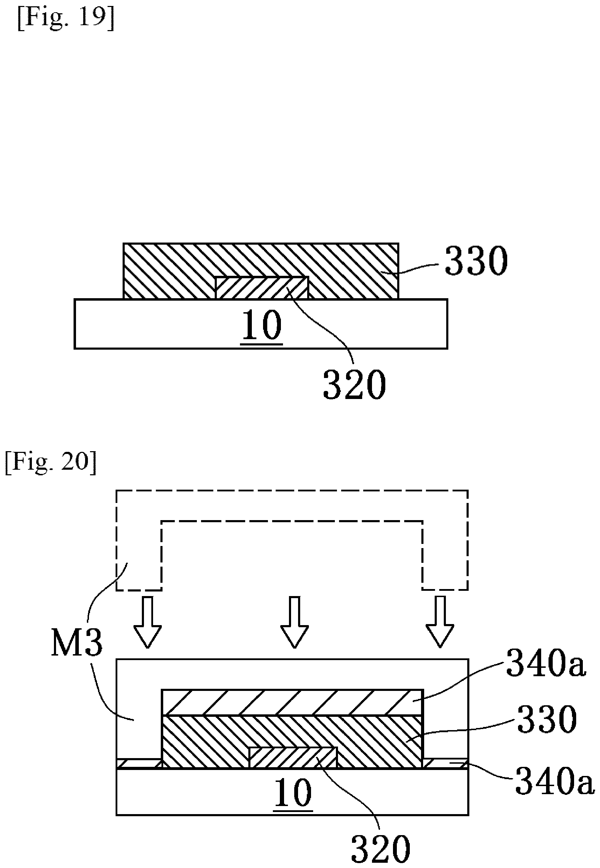

Subsequently, the precursor layer 330a is subjected to main annealing as in Second Embodiment. As a result, as shown in Fig. 19, an oxide layer 330 as a dielectric layer (note that it possibly includes inevitable impurities; the same applies hereinafter) is formed on the lower electrode layer 320. In the main annealing, the precursor layer 330a is heated under an oxygen atmosphere at a temperature in the range of 520°C or more and 620°C or less for a certain period of time.

In this main annealing step, the oxide layer 330 consisting essentially of bismuth (Bi) and niobium (Nb) can be obtained. More specifically, the oxide layer 330 according to this embodiment includes an oxide consisting essentially of bismuth (Bi) and niobium (Nb) and having a crystal phase of the pyrochlore-type crystal structure (including a microcrystal phase) as in First Embodiment. Moreover, in the above oxide layer 30, the number of atoms of niobium (Nb) is 1.3 or more and 1.7 or less when the number of atoms of bismuth (Bi) is take as 1.

Alternatively, the step of subjecting the entire surface of the precursor layer 330a to etching may be performed after the main annealing. However, in a more preferred mode, as described above, the step of entirely subjecting the precursor layer to etching should be performed between the imprinting step and the main annealing step. This is because the unnecessary region of each precursor layer can be more easily removed by etching before the main annealing than after the main annealing.

### (3) Formation of upper electrode layer

Subsequently, like the lower electrode layer 320, a precursor layer 340a for an upper electrode layer is formed on the oxide layer 330 by a known spin coating method using, as a starting material, a precursor solution containing a lanthanum (La)-containing precursor and a nickel (Ni)-containing precursor as solutes. Subsequently, preliminary annealing is performed, in which the precursor layer 340a for an upper electrode layer is heated in the temperature range of 80°C or more and 250°C or less in an oxygen-containing atmosphere.

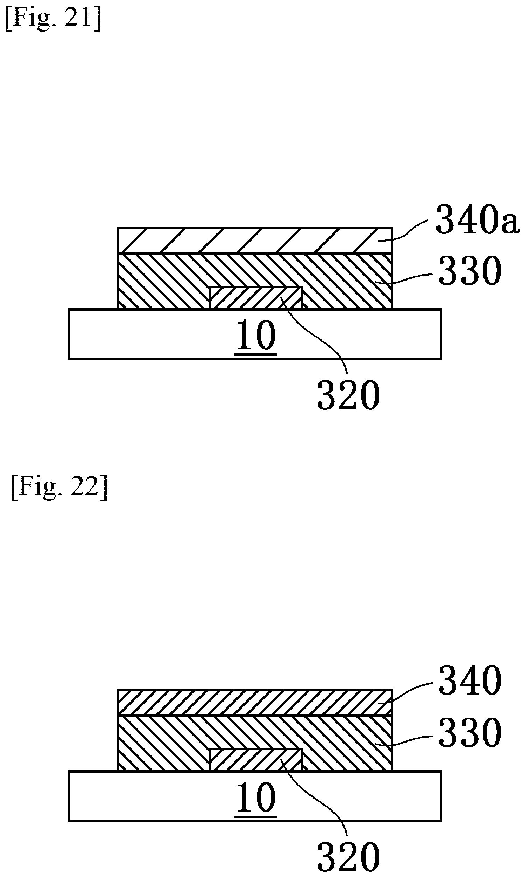

Subsequently, as shown in Fig. 20, the preliminarily-annealed precursor layer 340a for an upper electrode layer is patterned by imprinting at a pressure of 1 MPa or more and 20 MPa or less using an upper electrode layer-forming mold M3 while the precursor layer 340a is heated at 80°C or more and 300°C or less. Subsequently, as shown in Fig. 21, the entire surface of the precursor layer 340a for an upper electrode layer is subjected to etching so that the precursor layer 340a for an upper electrode layer is completely removed from a region other than the region corresponding to an upper electrode layer 340.

Subsequently, as shown in Fig. 22, main annealing is performed, in which the precursor layer 340a for an upper electrode layer is heated at 520°C to 600°C for a certain period of time in an oxygen atmosphere, so that an upper electrode layer 340 (possibly including inevitable impurities; the same applies hereinafter) consisting essentially of lanthanum (La) and nickel (Ni) is formed on the oxide layer 330.

In this embodiment, the oxide layer 330 consisting essentially of bismuth (Bi) and niobium (Nb) which is formed by heating a precursor layer under an oxygen-containing atmosphere, the precursor layer being prepared using a precursor solution as a starting material, the precursor solution including a precursor containing bismuth (Bi) and a precursor containing niobium (Nb) as solutes, is formed. Further, good electrical properties can be obtained in particular when the heating temperature for forming the above oxide layer is 520°C or more and 620°C or less. In addition, when the method of manufacturing an oxide layer according to this embodiment is used, the precursor solution for the oxide layer is simply heated under an oxygen-containing atmosphere without using any vacuum process. This enables easier large-area fabrication as compared to conventional sputtering, and can also significantly increase industrial or mass productivity.

Further, the thin film capacitor 300 of this embodiment includes the lower electrode 320, the oxide layer 330 as an insulating layer, and the upper electrode layer 340, which are provided on the substrate 10 and arranged in order from the substrate 10 side. As described above, each layer has an imprinted structure formed by imprinting. This can eliminate the need for a process that takes a relatively long time and/or requires an expensive facility, such as a vacuum process, a photolithographic process, or an ultraviolet exposure process. This enables simple patterning of all the electrode layers and the oxide layer. Therefore, the thin film capacitor 300 of this embodiment has excellent industrial or mass productivity.

### <Fourth Embodiment>

### 1. Overall structure of thin film capacitor according to this embodiment

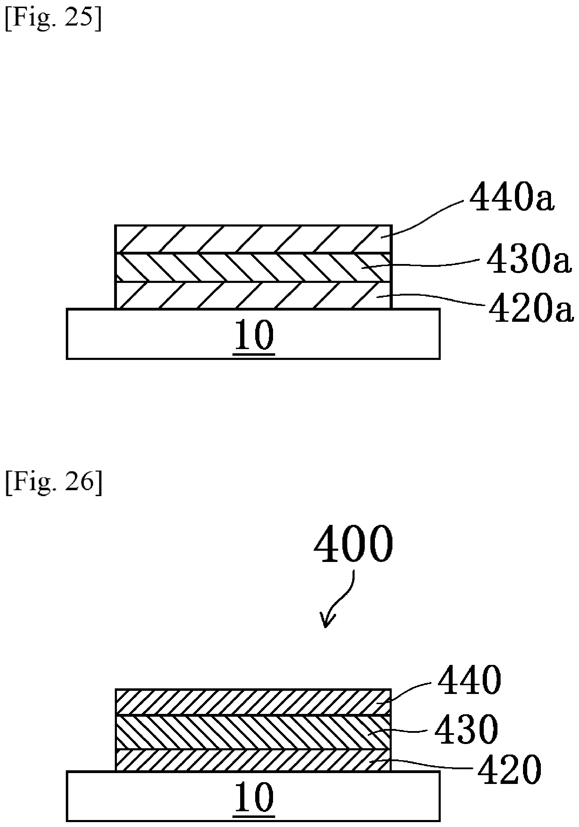

Again, in this embodiment, imprinting is performed in each layer-forming step for a thin film capacitor as an example of solid state electronic devices. Fig. 26 shows the overall structure of a thin film capacitor 400 as an example of solid state electronic devices according to this embodiment. In this embodiment, the lower electrode layer, the oxide layer, and the upper electrode layer are subjected to preliminary annealing after corresponding precursor layers are layered.

Further, the preliminarily-annealed precursor layers are all subjected to imprinting, and then to the main annealing. It is noted that repeated descriptions with respect to First to Third Embodiments will be omitted in the configuration according to this embodiment. As shown in Fig. 26, the thin film capacitor 400 is formed on a substrate 10. Further, the thin film capacitor 400 includes a lower electrode layer 420, an oxide layer 430 as an insulating layer including a dielectric, and an upper electrode layer 440 in this order from the substrate 10.

### 2. Process of manufacturing thin film capacitor 400

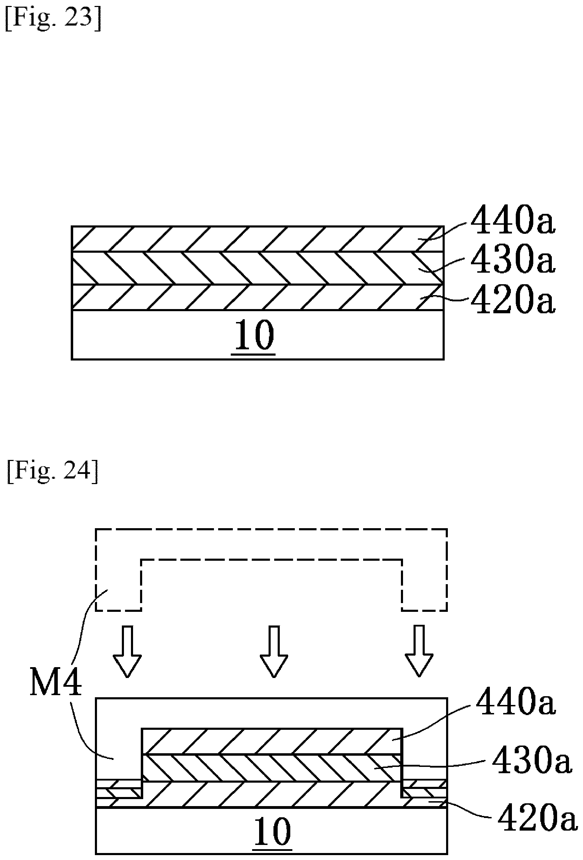

Next, a method of manufacturing the thin film capacitor 400 will be described. Figs. 23 to 25 are cross-sectional schematic views each showing a process in the method for manufacturing the thin film capacitor 400. For manufacturing the thin film capacitor 400, a precursor layer 420a for a lower electrode layer as a precursor layer of the lower electrode layer 420, a precursor layer 430a as a precursor layer of the oxide layer 430, and precursor layer 440a for an upper electrode layer as a precursor layer of the upper electrode layer 440 are formed on or above the substrate 10. Next, the resulting layered product is subjected to imprinting, and then to the main annealing. Repeated descriptions with respect to First to Third Embodiments will also be omitted in the process of manufacturing the thin film capacitor 400.

### (1) Formation of layered product of precursor layers

As shown in Fig. 23, the precursor layer 420a for a lower electrode layer as a precursor layer of the lower electrode layer 420, the precursor layer 430a as a precursor layer of the oxide layer 430, and the precursor layer 440a for an upper electrode layer as a precursor layer of the upper electrode layer 440 are formed on or above the substrate 10. As in Third Embodiment, this embodiment provides an example where the lower electrode layer 420 and the upper electrode layer 440 of the thin film capacitor 400 is made of a conductive oxide layer consisting essentially of lanthanum (La) and nickel (Ni), and the oxide layer 430 as a dielectric layer is made of an oxide layer consisting essentially of bismuth (Bi) and niobium (Nb).

First, the precursor layer 420a for a lower electrode layer is formed on the substrate 10 by a known spin coating method using, as a starting material, a lower electrode layer-forming precursor solution including a lanthanum (La)-containing precursor and a nickel (Ni)-containing precursor as solutes. Subsequently, preliminary annealing is performed, in which the precursor layer 420a for a lower electrode layer is heated at a temperature in the range of 80°C or more and 250°C or less for a certain period of time under an oxygen-containing atmosphere. The formation of the precursor layer 420a for a lower electrode layer by spin coating and the preliminary annealing may also be repeated a plurality of times, so that the lower electrode layer 420 can be formed with a desired thickness.

Next, the precursor layer 430a is formed on the precursor layer 420a for a lower electrode layer which has been subjected to the preliminary annealing. First, the precursor layer 430a prepared using a precursor solution as a starting material is formed on the precursor layer 420a for a lower electrode layer, the precursor solution including a precursor containing bismuth (Bi) and a precursor containing niobium (Nb) as solutes. Subsequently, preliminary annealing is performed, in which the precursor layer 430a is heated at a temperature in the range of 80°C or more and 250°C or less for a certain period of time under an oxygen-containing atmosphere.

Next, as in the precursor layer 420a for a lower electrode layer, the precursor layer 440a for an upper electrode layer is formed on the preliminarily-annealed precursor layer 430a by a known spin coating method, the precursor layer 440a for an upper electrode layer being prepared using a precursor solution as a starting material, the precursor solution including a lanthanum (La)-containing precursor and a nickel (Ni)-containing precursor as solutes. Subsequently, preliminary annealing is performed, in which the precursor layer 440a for an upper electrode layer is heated at a temperature in the range of 80°C or more and 250°C or less under an oxygen-containing atmosphere.

### (2) Imprinting

Next, as shown in Fig. 24, the layered product (420a, 430a, 440a) of each precursor layer is patterned by performing imprinting at a pressure of 1 MPa or more and 20 MPa or less using a layered product-forming mold M4 while heated at a temperature in the range of 80°C or more and 300°C or less.

Subsequently, the entire surface of the layered product (420a, 430a, 440a) of each precursor layer is subjected to etching. As a result, as shown in Fig. 25, the layered product (420a, 430a, 440a) of each precursor layer is completely removed from a region other than the regions corresponding to the lower electrode layer, the oxide layer, and the upper electrode layer (a step of etching the entire surface of the layered product (420a, 430a, 440a) of each precursor layer).

### (3) Main annealing

Next, the layered product (420a, 430a, 440a) of each precursor layer is subjected to the main annealing. As a result, as shown in Fig. 26, the lower electrode layer 420, the oxide layer 430, and the upper electrode layer 440 are formed on or above the substrate 10.

Again in this embodiment, the oxide layer 430 consisting essentially of bismuth (Bi) and niobium (Nb) which is formed by heating a precursor layer under an oxygen-containing atmosphere, the precursor layer being prepared using a precursor solution as a starting material, the precursor solution including a precursor containing bismuth (Bi) and a precursor containing niobium (Nb) as solutes, is formed. It is noted that as in First Embodiment, the number of atoms of bismuth (Bi) and the number of atoms of niobium (Nb) as solutes in the precursor solution according to this embodiment are adjusted such that the number of atoms of niobium (Nb) is 1.3 or more and 1.7 or less (typically 1.5) when the number of atoms of bismuth (Bi) in the above precursor containing bismuth (Bi) is assumed to be 1.

After performing the main annealing step as described above, the oxide layer 430 consisting essentially of bismuth (Bi) and niobium (Nb) is obtained. More specifically, the oxide layer 430 according to this embodiment includes an oxide consisting essentially of bismuth (Bi) and niobium (Nb) and having a crystal phase of the pyrochlore-type crystal structure (including a microcrystal phase) as in First Embodiment. Moreover, in the above oxide layer 30, the number of atoms of niobium (Nb) is 1.3 or more and 1.7 or less when the number of atoms of bismuth (Bi) is take as 1.

It is noted that particularly good electrical properties can be obtained when the heating temperature for forming the oxide layer 430 is 520°C or more and 620°C or less. In addition, when the method of manufacturing an oxide layer according to this embodiment is used, the precursor solution for the oxide layer is simply heated under an oxygen-containing atmosphere without using any vacuum process. This enables easier large-area fabrication as compared to conventional sputtering, and can also significantly increase industrial or mass productivity.

Further, in this embodiment, the main annealing is performed after the precursor layers of all preliminarily-annealed oxide layers are imprinted. Therefore, the process can be shortened when an imprinted structure is formed.

As described above, the oxide layer according to each of the embodiments described above, in which crystal phases of the pyrochlore-type crystal structure are dispersed, has a higher dielectric constant than ever as a BNO oxide. Further, the results demonstrate that an oxide dielectric having a specific composition ratio where the number of atoms of niobium (Nb) is 1.3 or more and 1.7 or less when the number of atoms of bismuth (Bi) is assumed to be 1 can show a particularly high relative dielectric constant. Furthermore, the results also demonstrate that an oxide dielectric with a high dielectric constant can be more reliably obtained by selecting a precursor prepared using a precursor solution as a starting material, the precursor solution including a precursor containing bismuth (Bi) and a precursor containing niobium (Nb) in which the number of atoms of the above niobium (Nb) is 1.3 or more and 1.7 or less when the number of atoms of the above bismuth (Bi) is assumed to be 1.

In addition, the manufacturing process can be simplified because the oxide layer according to each of the embodiments described above is manufactured by the solution technique. Further, according to the method of manufacturing an oxide layer by the solution technique, a BNO oxide layer having good electrical properties such as a high relative dielectric constant and low dielectric loss can be obtained when the heating temperature for forming an oxide layer (the temperature at the main annealing) is 520°C or more and 620°C or less. Moreover, the method of manufacturing an oxide layer according to each of the embodiments described above can be performed in relatively short time by a simple way without need of complex and expensive equipment such as vacuum apparatus. This can significantly contribute to provision of oxide layers with superior industrial and mass productivity and various solid state electronic devices having such oxide layers.

### <Other embodiments>

Meanwhile, the post-annealing treatment is not performed for the oxide layer in Third or Fourth Embodiment. However, in a preferred embodiment, the post-annealing treatment may be performed as a modified version of Third or Fourth Embodiment. For example, the post-annealing treatment may be performed after the imprinting and the patterning are completed. The post-annealing treatment may provide effects similar to those described in Second Embodiment.

The oxide layer according to each embodiment described above is suitable for various solid state electronic devices for controlling large currents at low driving voltages. The oxide layer according to each embodiment described above is also suitable for use in many other solid state electronic devices besides the thin film capacitors described above. For example, the oxide layer according to each embodiment described above is suitable for use in capacitors such as multilayer thin film capacitors and variable capacitance thin film capacitors; semiconductor devices such as metal oxide semiconductor field-effect transistors (MOSFETs) and nonvolatile memories; devices for small electromechanical systems typified by microelectromechanical systems (MEMS) or nanoelectromechanical systems (NEMS) such as micro total analysis systems (TASs), micro chemical chips, and DNA chips; or other devices such as a combined device including at least two of a high frequency filter, a patch antenna, or an RCL.

In the above embodiment where imprinting is performed, the pressure during the imprinting is set in the range of "1 MPa or more and 20 MPa or less" for the reasons below. If the pressure is less than 1 MPa, the pressure may be too low to successfully imprint each precursor layer. On the other hand, a pressure of 20 MPa is high enough to sufficiently imprint the precursor layer, and there is no need to apply any pressure higher than 20 MPa. From the above points of view, the imprinting is more preferably performed at a pressure in the range of 2 MPa or more and 10 MPa or less in the imprinting step.

As described above, each of the above embodiments has been disclosed not for limiting the present invention but for describing these embodiments. Furthermore, modification examples made within the scope of the present invention, inclusive of other combinations of the embodiments, will be also included in the scope of claims.

### DESCRIPTION OF REFERENCE SIGNS

10: Substrate
20, 320, 420: Lower electrode layer
320a, 420a: Precursor layer for lower electrode layer
30, 330, 430: Oxide layer (oxide dielectric layer)
30a, 330a, 430a: Precursor layer for oxide layer
40, 340, 440: Upper electrode layer
340a, 440a: Precursor layer for upper electrode layer
100, 200, 300, 400: Thin film capacitor as example of solid state electronic device
M1 : Lower electrode layer-forming mold
M2: Dielectric layer-forming mold
M3: Upper electrode layer-forming mold
M4: Layered product-forming mold

## Claims

1. An oxide dielectric, comprising an oxide (possibly including inevitable impurities) consisting essentially of bismuth (Bi) and niobium (Nb), and having a crystal phase of the pyrochlore-type crystal structure,
wherein the number of atoms of the niobium (Nb) is 1.3 or more and 1.7 or less when the number of atoms of the bismuth (Bi) is assumed to be 1.

2. The oxide dielectric according to claim 1, wherein the oxide further comprises an oxide consisting essentially of the bismuth (Bi) and the niobium (Nb) and having an amorphous phase.

3. The oxide dielectric according to claim 1 or 2, wherein the oxide is formed by heating a precursor under an oxygen-containing atmosphere, the precursor being prepared using a precursor solution as a starting material, the precursor solution comprising, as solutes, a precursor containing the bismuth (Bi) and a precursor containing the niobium (Nb) in which the number of atoms of the niobium (Nb) is 1.3 or more and 1.7 or less when the number of atoms of the bismuth (Bi) is assumed to be 1.

4. A solid state electronic device, comprising the oxide dielectric according to any one of claims 1 to 3.

5. The solid state electronic device according to claim 4, wherein the solid state electronic device is selected from the group consisting of high frequency filters, patch antennas, capacitors, semiconductor devices, and microelectromechanical systems.

6. A method of manufacturing an oxide dielectric, comprising a step of
heating a precursor layer under an oxygen-containing atmosphere at a first temperature of 520°C to 620°C, the precursor layer being prepared using a precursor solution as a starting material, the precursor solution containing, as solutes, a precursor containing bismuth (Bi) and a precursor containing niobium (Nb) in which the number of atoms of the niobium (Nb) is 1.3 or more and 1.7 or less when the number of atoms of the bismuth (Bi) is assumed to be 1,
to form an oxide dielectric layer comprising an oxide (possibly including inevitable impurities) consisting essentially of the bismuth (Bi) and the niobium (Nb) and having a crystal phase of the pyrochlore-type crystal structure in which the number of atoms of the niobium (Nb) is 1.3 or more and 1.7 or less when the number of atoms of the bismuth (Bi) is assumed to be 1.

7. The method of manufacturing an oxide dielectric according to claim 6, wherein the oxide further comprises an oxide consisting essentially of the bismuth (Bi) and the niobium (Nb) and having an amorphous phase.

8. The method of manufacturing an oxide dielectric according to claim 6 or 7, further comprising an additional heating step of heating the precursor layer at a second temperature equal to or lower than the first temperature after heating under the oxygen-containing atmosphere.

9. The method of manufacturing an oxide dielectric according to any one of claims 6 to 8, comprising imprinting the precursor layer while heating the precursor layer at 80°C or more and 300°C or less under an oxygen-containing atmosphere to form an imprinted structure at the precursor layer before forming the oxide dielectric layer.

10. The method of manufacturing an oxide dielectric according to claim 9, comprising performing the imprinting at a pressure in the range of 1 MPa or more and 20 MPa or less.

11. A method of manufacturing a solid state electronic device, wherein the solid state electronic device comprises the oxide dielectric according to any one of claims 6 to 10.

12. A precursor of an oxide dielectric, which is a precursor of an oxide consisting essentially of bismuth (Bi) and niobium (Nb) and having a crystal phase of the pyrochlore-type crystal structure,
wherein the precursor comprises mixed solutes of a precursor containing the bismuth (Bi) and a precursor containing the niobium (Nb) in which the number of atoms of the niobium (Nb) is 1.3 or more and 1.7 or less when the number of atoms of the bismuth (Bi) is assumed to be 1.
